# EUROPEAN PATENT APPLICATION

(11) **EP 3 573 222 A1**
(43) Date of publication of application: **27.11.2019**
(21) Application number: 19175169.2
(22) Date of filing: 17.05.2019
(51) Int. Cl.: H02K 9/00, F25B 23/00, F25B 9/00

(54) **SUPERCRITICAL COOLING SYSTEM**

(30) Priority: 22.05.2018 US 201862674980 P; 13.12.2018 US 201816219540
(71) Applicant: General Electric Company, Schenectady, NY 12345 (US)
(72) Inventor: DE BOCK, Hendrik, Niskayuna, NY New York 12309 (US); GERSTLER, William, Niskayuna, NY New York 12309 (US)
(74) Representative: Openshaw & Co.

(57) **Abstract**

A supercritical cooling system (200) and method (300) increases a pressure of a cooling fluid in a cooling circuit (206) to a pressure above a supercritical pressure of the cooling fluid. The cooling fluid is in a supercritical state at a temperature to which the cooling circuit (206) is exposed. The cooling fluid is moved through the cooling circuit (206) while the cooling fluid is in the supercritical state. A machine is cooled using the cooling fluid in the supercritical state while the cooling fluid moves in the cooling circuit (206).

## Description

### CROSS-REFERENCE TO RELATED APPLICATIONS

This application claims priority to U.S. Provisional Application No. 62/674,980, which was filed on 22-May-2018, and the entire disclosure of which is incorporated herein by reference.

### FIELD

The subject matter described herein relates to cooling systems for machines.

### BACKGROUND

Various types of machines generate significant heat while operating, and can require cooling to allow the machines to continue operating. For example, electric machines, such as motors, can generate significant heat due to the exposure of conductive components of the motor in time-varying magnetic fields during operation of the motor. These conductive components can require cooling to allow the motor to continue operating.

Some cooling systems for these types of machines circulate coolants, such as water, water-PG/EG, or oil. Water or water-PG/EG mixtures are limited in operating temperature use, typically with an upper temperature limit of 100 to 120 degrees Celsius. These coolants may not be able to operate to cool machines at temperatures in or above this range. Additionally, these fluids have poor dielectric performance (e.g., the fluids are too conductive) unless the fluids are in very pure state. Oil, on the other hand, has better dielectric properties, but has high viscosity and thermal conductivity. Therefore, using oil as a cooling fluid can require significant pumping power or significantly reduced cooling performance.

### BRIEF DESCRIPTION

In one embodiment, a method includes increasing a pressure of a cooling fluid in a cooling circuit. The pressure of the cooling fluid is increased above a supercritical pressure of the cooling fluid. The cooling fluid is in a supercritical state at a temperature to which the cooling circuit is exposed. The method also includes moving the cooling fluid through the cooling circuit while the cooling fluid is in the supercritical state, and cooling a machine using the cooling fluid in the supercritical state while the cooling fluid moves in the cooling circuit.

In one embodiment, a supercritical state cooling system includes a cooling circuit formed from one or more conduits disposed in or alongside a machine and one or more pumps fluidly coupled with the cooling circuit. The one or more pumps are configured to increase a pressure of a cooling fluid in the cooling circuit to above a supercritical pressure of the cooling fluid. The cooling fluid is in a supercritical state at a temperature to which the cooling circuit is exposed. The one or more pumps also are configured to move the cooling fluid through the cooling circuit while the cooling fluid is in the supercritical state to cool the machine using the cooling fluid in the supercritical state while the cooling fluid moves in the cooling circuit.

In one embodiment, a supercritical state cooling system includes a cooling circuit formed from one or more conduits disposed in or alongside a machine, one or more temperature sensors configured to measure a temperature of a cooling fluid in the cooling circuit, and a controller configured to monitor the temperature of the cooling fluid and a pressure of the cooling fluid in the cooling circuit. The controller is configured to activate one or more pumps to increase the pressure of the cooling fluid to above a supercritical pressure limit responsive and subsequent to the temperature of the cooling fluid increasing above a supercritical temperature limit associated with a supercritical state of the cooling fluid. The controller is configured to control the one or more pumps to increase the pressure of the cooling fluid to above the supercritical pressure of the cooling fluid to keep the cooling fluid in a supercritical state while the cooling fluid moves in the cooling circuit to cool the machine.

### BRIEF DESCRIPTION OF THE DRAWINGS

The present inventive subject matter will be better understood from reading the following description of non-limiting embodiments, with reference to the attached drawings, wherein below:
Figure 1 illustrates one example of a phase diagram for a cooling fluid;
Figure 2 schematically illustrates one embodiment of a supercritical cooling system; and
Figure 3 illustrates a flowchart of one embodiment of a method for cooling a machine using a supercritical coolant.

### DETAILED DESCRIPTION

The subject matter described herein relates to cooling systems and methods that use cooling fluids in a supercritical state to cool components of powered systems. The components that are cooled can include electrical machines, such as motors, transformers, and the like. The coolants described herein can be supercritical refrigerants that have superior heat transfer performance (relative to other known coolants) and are able to operate at elevated temperatures (e.g., temperatures above 135 degrees Celsius). Examples of refrigerants that may be used as supercritical coolants in one or more embodiments described herein include the refrigerants R134A, Carbon dioxide and/or R1234yf.

The supercritical coolants can be used in a cooling loop or circuit that is embedded within a powered system. This can allow for the supercritical coolants to be held or move closer to the limits of the insulation, with superior heat transfer performance, thereby raising the temperature of the rejection heat sink to near the heat source junction and/or reducing required pumping power (that may otherwise be needed for more viscous coolants).

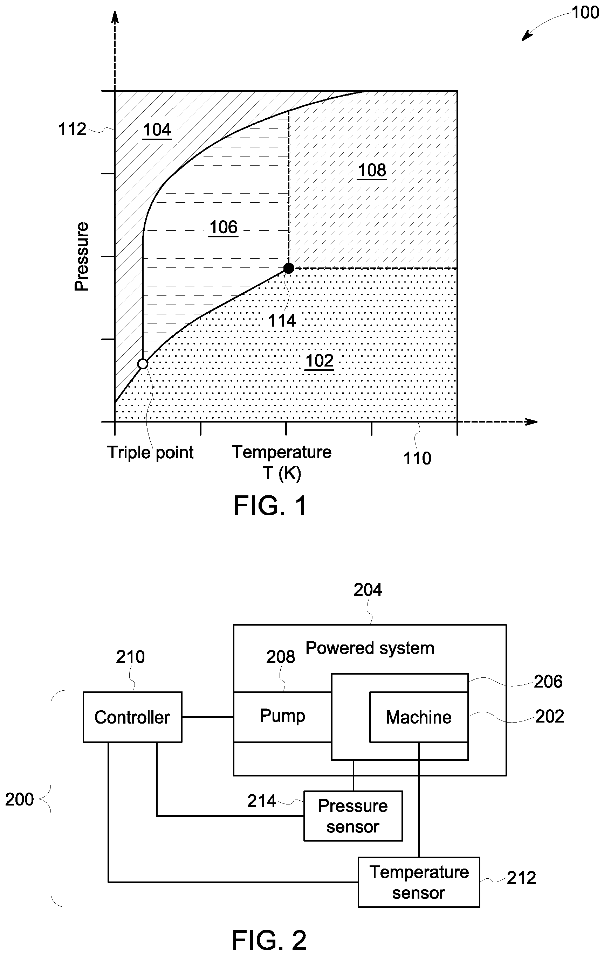

A supercritical fluid is a substance in conditions beyond a critical point associated with the fluid, such as when the fluid is at temperatures above a critical temperature and at pressures above a critical pressure. Figure 1 illustrates one example of a phase diagram 100 for a cooling fluid (also referred to herein as a coolant). The phase diagram 100 shows several different areas 102, 104, 106, 108 shown alongside a horizontal axis 110 and a vertical axis 112. Each area 102, 104, 106, 108 represents a different phase of the same coolant. The horizontal axis 110 represents different temperatures, and the vertical axis 112 represents different pressures. At temperatures and pressures within the first area 102, the coolant is in a gaseous state. At greater pressures, the coolant may transition to another state depending on the temperature of the coolant. For example, the coolant may transition to a solid state (e.g., the second area 104) at lower temperatures, or to a liquid state (e.g., the third area 106) at hotter temperatures.

A critical point 114 represents lower limits on temperature and pressure that, above which, the coolant transitions to a supercritical state (e.g., the fourth area 108). The critical point 114 represents the highest temperature and pressure at which the coolant can exist as a vapor and liquid in equilibrium. In the supercritical state, some coolants (e.g., the refrigerant R1234yf, as one example) can have the density of liquid but the viscosity of a gas, and be able to operate as a dielectric be able to operate in high temperatures (e.g., temperatures above 130 degrees Celsius). The reduced density and viscosity of the supercritical coolant can allow for the coolant to more easily move through a cooling circuit (thereby reducing the pumping power needed to move the coolant), while the ability of the supercritical coolant to operate in hotter temperatures can allow for the supercritical coolant to more efficiently cool a machine. This can allow for the cooling system that uses the supercritical fluid to be smaller in size and optionally consume less power than currently known cooling systems (to cool the same machine by an equivalent amount). For example, a cooling system using the supercritical coolant can be two to three times smaller than known cooling systems that do not use supercritical coolants.

Figure 2 schematically illustrates one embodiment of a supercritical cooling system 200. The cooling system 200 can operate to reduce a temperature of one or more machines 202 of a powered system 204. As one example, the machine 202 can represent an electric machine, such as an electric motor, a transformer, or the like. The powered system 204 can represent a vehicle, aircraft, stationary power generator, or the like, that is at least partially powered by operation of the machine 202. The machine 202 can generate significant heat during operation such that cooling of the machine 202 is required to allow the machine 202 to continue operating for extended periods of time. The cooling system 200 operates to cool temperatures of the machine 202.

The cooling system 200 includes a cooling circuit 206. The cooling circuit 206 includes one or more conduits, containers, jackets, or the like, that hold a pressurized coolant as described herein. The cooling circuit 206 may at least partially enclose, abut against, or otherwise be close to the machine 202 to cool the machine 202. For example, the machine 202 may be at least partially disposed in a cooling jacket of the cooling circuit 206, a conduit of the cooling circuit 206 may abut the machine 202, or the like. One or more pumps 208 are fluidly coupled with the cooling circuit 206 and operate to control (e.g., increase) a pressure of the coolant inside the cooling circuit 206. Increasing the pressure of the coolant by the pump 208 also can cause the coolant to move within the circuit 206, thereby cooling the machine 202.

A controller 210 of the cooling system 200 represents hardware circuitry that includes and/or is connected with one or more processors (e.g., one or more microprocessors, one or more field programmable gate arrays, and/or one or more integrated circuits). The processor(s) of the controller 210 operate to monitor the conditions of the coolant and/or machine 202, and to control operation of the pump 208 accordingly (as described herein). For example, the controller 210 can communicate (e.g., via wired and/or wireless connections) with a temperature sensor 212 and a pressure sensor 214. The temperature sensor 212 can measure temperatures of the coolant in the cooling circuit 206, and/or temperatures at which the machine 202 is operating. The pressure sensor 214 can measure the pressure of the coolant in the cooling circuit 206. The controller 210 can use this information to determine when to change the pressure of the coolant in the circuit 206 (e.g., using the pump 208) to transition the coolant from a gas state to a supercritical state.

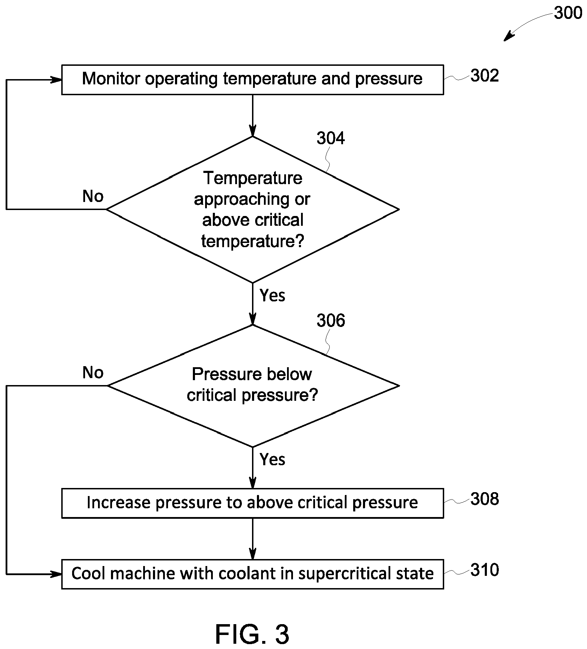

With continued reference to the supercritical cooling system 200 shown in Figure 2, Figure 3 illustrates a flowchart of one embodiment of a method 300 for cooling a machine using a supercritical coolant. The method 300 can represent operations performed by the cooling system 200, such as the operations performed and/or dictated by the controller 210.

At 302, an operating temperature and pressure are monitored. The operating temperature can be the temperature of coolant in the cooling circuit 206, which may not yet be in a supercritical state. For example, the coolant in the cooling circuit 206 may be in the gas phase or state at a current operating temperature and pressure. Optionally, the operating temperature can be the temperature of the machine being cooled by the cooling system 200. For example, the operating temperature can be the temperature of an electric motor (or other electronic machine), the environment around the electric motor (or other electronic machine), or the like. The operating pressure can be the pressure of the coolant in the cooling circuit 206. The pressure may be too low for the coolant to be in the supercritical state. For example, the current temperature and/or pressure of the coolant may be below the temperature and pressure of the critical point 114. The temperature and/or pressure can be monitored by the controller 210 examining signals output by the sensors 212, 214, which indicate or represent the operating temperature and pressure.

At 304, a determination is made as to whether the operating temperature is approaching or above the critical temperature of the coolant. For example, the controller 210 can compare the operating temperature with a designated critical temperature of the coolant. Different coolants have different critical temperatures. The controller 210 can store (or have access to a tangible and non-transitory computer readable memory, such as a computer hard drive, flash drive, or the like) the critical temperature of the coolant in the cooling circuit 206, and compare the operating temperature with the critical temperature.

If the operating temperature is approaching or is above the critical temperature, then the pressure of the coolant may need to be increased to transition the coolant into the supercritical state. The operating temperature may be approaching the critical temperature if the operating temperature is below the critical temperature, but is increasing at a rate that will result in the operating temperature increasing above the critical temperature during a current duty or operating cycle of the machine. If the operating temperature is approaching or is above the critical temperature, then flow of the method 300 can proceed toward 306. Otherwise, if the operating temperature is not yet above and is not approaching the critical temperature, then flow of the method 300 can return toward 302. For example, the controller 210 can continue monitoring the operating temperature of the coolant and/or machine.

At 306, a determination is made as to whether the operating pressure is below the critical pressure of the coolant. For example, the controller 210 can compare the operating pressure with a designated critical pressure of the coolant. Different coolants have different critical pressures. The controller 210 can store (or have access to a tangible and non-transitory computer readable memory, such as a computer hard drive, flash drive, or the like) the critical pressure of the coolant in the cooling circuit 206, and compare the operating pressure with the critical pressure.

If the operating pressure is below the critical pressure, then the pressure of the coolant may need to be increased to transition the coolant into the supercritical state. If the operating pressure is below the critical pressure, then flow of the method 300 can proceed toward 308. Otherwise, if the operating pressure is already above the critical pressure, then the coolant may already be in the critical state. As a result, flow of the method 300 can proceed toward 310.

At 308, the pressure of the coolant is increased to a pressure that is greater than the critical pressure. The controller 210 can activate or increase an operating speed of the pump(s) 208. The pump(s) 208 can operate to increase the pressure of the coolant in the cooling circuit 206, such as by pumping in additional coolant into the cooling circuit 206, increasing the rate at which the coolant flows in the cooling circuit 206, or the like. The pressure of the coolant can be increased to above the critical pressure to ensure that the coolant is in the critical state.

At 310, the machine is cooled with the coolant in the supercritical state. The pump(s) 208 can continue moving the supercritical coolant through the cooling circuit 206, which can draw heat away from the machine 202 and into the supercritical coolant to assist in cooling the machine 202. The cooling circuit 206 may include a path that directs the supercritical coolant away from the machine 202 so that the thermal energy absorbed by the supercritical coolant while flowing across or near the machine 202 is transferred to the ambient environment or another location (e.g., a heat sink). This helps to carry the heat away from the machine 202 to help cool the machine 202.

The controller 210 can continue to monitor the operating temperature and pressure of the coolant to ensure that the coolant is in the supercritical state represented by the area 108 in Figure 1. The controller 210 can control the pump(s) 208 to vary the pressure of the coolant to keep the coolant pressure above the critical pressure so long as the temperature of the coolant remains at or above the critical temperature. This can ensure that the coolant remains in the supercritical state so long as the cooling system 200 is operating to cool the machine 202.

The cooling system 200 can operate to cool the machine 202 without using a vapor-compression cycle for the coolant. Such a cycle for some cooling systems involves evaporating a coolant (using heat from a component to be cooled) and then condensing the evaporated coolant (to transfer the heat elsewhere away from the component). These types of cooling systems may require a complex system of pumps, condenser coils, and the like. Additionally, the effectiveness of these types of cooling systems can be limited at elevated temperatures. In contrast, at least one embodiment of the cooling system 200 can involve cooling the machine 202 with the supercritical coolant, but without evaporating or condensing the coolant. The coolant may draw heat from the machine 202 due to the properties of the coolant in the supercritical state, and without having to evaporate or condense the coolant.

In one embodiment, a method includes increasing a pressure of a cooling fluid in a cooling circuit. The pressure of the cooling fluid is increased above a supercritical pressure of the cooling fluid. The cooling fluid is in a supercritical state at a temperature to which the cooling circuit is exposed. The method also includes moving the cooling fluid through the cooling circuit while the cooling fluid is in the supercritical state, and cooling a machine using the cooling fluid in the supercritical state while the cooling fluid moves in the cooling circuit.

Optionally, moving the cooling fluid through the cooling circuit and cooling the machine using the cooling fluid in the supercritical state does not include evaporating or condensing the cooling fluid.

Optionally, moving the cooling fluid through the cooling circuit includes pumping the cooling fluid through conduits that form the cooling circuit without condensing the cooling fluid.

Optionally, the supercritical pressure of the cooling fluid is a pressure at which the cooling fluid transitions from a liquid state to a supercritical state at the temperature to which the cooling circuit is exposed.

Optionally, the method also includes maintaining the cooling fluid in a supercritical state above the supercritical pressure while cooling the machine.

Optionally, moving the cooling fluid through the cooling circuit includes activating one or more pumps that move the cooling fluid through conduits of the cooling circuit responsive and subsequent to the temperature to which the cooling circuit is exposed increasing above a supercritical temperature limit associated with the supercritical state of the cooling fluid.

Optionally, the cooling fluid is a refrigerant.

Optionally, the machine includes one or more of an electric motor or a transformer.

In one embodiment, a supercritical state cooling system includes a cooling circuit formed from one or more conduits disposed in or alongside a machine and one or more pumps fluidly coupled with the cooling circuit. The one or more pumps are configured to increase a pressure of a cooling fluid in the cooling circuit to above a supercritical pressure of the cooling fluid. The cooling fluid is in a supercritical state at a temperature to which the cooling circuit is exposed. The one or more pumps also are configured to move the cooling fluid through the cooling circuit while the cooling fluid is in the supercritical state to cool the machine using the cooling fluid in the supercritical state while the cooling fluid moves in the cooling circuit.

Optionally, the one or more pumps are configured to move the cooling fluid through the cooling circuit and cool the machine using the cooling fluid in the supercritical state without evaporating or condensing the cooling fluid.

Optionally, the one or more pumps are configured to move the cooling fluid through the cooling circuit by pumping the cooling fluid through conduits that form the cooling circuit without condensing the cooling fluid.

Optionally, the supercritical pressure of the cooling fluid is a pressure at which the cooling fluid transitions from a liquid state to a supercritical state at the temperature to which the cooling circuit is exposed.

Optionally, the system also includes a controller configured to monitor the pressure of the cooling fluid and to control the one or more pumps to maintain the cooling fluid in a supercritical state above the supercritical pressure while cooling the machine.

Optionally, the system also includes one or more temperature sensors and a controller configured to monitor a temperature of the cooling fluid using the one or more temperature sensors. The controller can be configured to activate the one or more pumps to begin increasing the pressure of the cooling fluid responsive and subsequent to the temperature of the cooling fluid increasing above a supercritical temperature limit associated with the supercritical state of the cooling fluid.

Optionally, the cooling fluid is a refrigerant.

Optionally, the machine includes one or more of an electric motor or a transformer.

In one embodiment, a supercritical state cooling system includes a cooling circuit formed from one or more conduits disposed in or alongside a machine, one or more temperature sensors configured to measure a temperature of a cooling fluid in the cooling circuit, and a controller configured to monitor the temperature of the cooling fluid and a pressure of the cooling fluid in the cooling circuit. The controller is configured to activate one or more pumps to increase the pressure of the cooling fluid to above a supercritical pressure limit responsive and subsequent to the temperature of the cooling fluid increasing above a supercritical temperature limit associated with a supercritical state of the cooling fluid. The controller is configured to control the one or more pumps to increase the pressure of the cooling fluid to above the supercritical pressure of the cooling fluid to keep the cooling fluid in a supercritical state while the cooling fluid moves in the cooling circuit to cool the machine.

Optionally, the one or more pumps are configured to move the cooling fluid through the cooling circuit and cool the machine using the cooling fluid in the supercritical state without evaporating or condensing the cooling fluid.

Optionally, the supercritical pressure of the cooling fluid is the pressure of the cooling fluid at which the cooling fluid transitions from a liquid state to a supercritical state as a function of the temperature of the cooling fluid.

Optionally, the cooling fluid is a refrigerant.

It is to be understood that the above description is intended to be illustrative, and not restrictive. For example, the above-described embodiments (and/or aspects thereof) may be used in combination with each other. In addition, many modifications may be made to adapt a particular situation or material to the teachings of the inventive subject matter without departing from its scope. While the dimensions and types of materials described herein are intended to define the parameters of the inventive subject matter, they are by no means limiting and are exemplary embodiments. Many other embodiments will be apparent to one of ordinary skill in the art upon reviewing the above description. The scope of the inventive subject matter should, therefore, be determined with reference to the appended claims, along with the full scope of equivalents to which such claims are entitled. In the appended claims, the terms "including" and "in which" are used as the plain-English equivalents of the respective terms "comprising" and "wherein." Moreover, in the following claims, the terms "first," "second," and "third," etc. are used merely as labels, and are not intended to impose numerical requirements on their objects. Further, the limitations of the following claims are not written in means-plus-function format and are not intended to be interpreted based on 35 U.S.C. § 112(f), unless and until such claim limitations expressly use the phrase "means for" followed by a statement of function void of further structure.

This written description uses examples to disclose several embodiments of the inventive subject matter, including the best mode, and also to enable one of ordinary skill in the art to practice the embodiments of inventive subject matter, including making and using any devices or systems and performing any incorporated methods. The patentable scope of the inventive subject matter is defined by the claims, and may include other examples that occur to one of ordinary skill in the art. Such other examples are intended to be within the scope of the claims if they have structural elements that do not differ from the literal language of the claims, or if they include equivalent structural elements with insubstantial differences from the literal languages of the claims.

The foregoing description of certain embodiments of the present inventive subject matter will be better understood when read in conjunction with the appended drawings. The various embodiments are not limited to the arrangements and instrumentality shown in the drawings.

As used herein, an element or step recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising," "comprises," "including," "includes," "having," or "has" an element or a plurality of elements having a particular property may include additional such elements not having that property.

Further aspects of the invention are provided by the subject-matter of the following numbered clauses:
1. A method comprising:
   increasing a pressure of a cooling fluid in a cooling circuit to above a supercritical pressure of the cooling fluid, wherein the cooling fluid is in a supercritical state at a temperature to which the cooling circuit is exposed;
   moving the cooling fluid through the cooling circuit while the cooling fluid is in the supercritical state; and
   cooling a machine using the cooling fluid in the supercritical state while the cooling fluid moves in the cooling circuit.
2. The method of any preceding clause, wherein moving the cooling fluid through the cooling circuit and cooling the machine using the cooling fluid in the supercritical state does not include evaporating or condensing the cooling fluid.
3. The method of any preceding clause, wherein moving the cooling fluid through the cooling circuit includes pumping the cooling fluid through conduits that form the cooling circuit without condensing the cooling fluid.
4. The method of any preceding clause, wherein the supercritical pressure of the cooling fluid is a pressure at which the cooling fluid transitions from a liquid state to a supercritical state at the temperature to which the cooling circuit is exposed.
5. The method of any preceding clause, further comprising maintaining the cooling fluid in the supercritical state above the supercritical pressure while cooling the machine.
6. The method of any preceding clause, wherein moving the cooling fluid through the cooling circuit includes activating one or more pumps that move the cooling fluid through conduits of the cooling circuit responsive and subsequent to the temperature to which the cooling circuit is exposed increasing above a supercritical temperature limit associated with the supercritical state of the cooling fluid.
7. The method of any preceding clause, wherein the cooling fluid is a refrigerant.
8. The method of any preceding clause, wherein the machine includes one or more of an electric motor or a transformer.
9. A supercritical state cooling system, the cooling system comprising:
   a cooling circuit formed from one or more conduits disposed in or alongside a machine; and
   one or more pumps fluidly coupled with the cooling circuit, the one or more pumps configured to increase a pressure of a cooling fluid in the cooling circuit to above a supercritical pressure of the cooling fluid, wherein the cooling fluid is in a supercritical state at a temperature to which the cooling circuit is exposed,
   wherein the one or more pumps also are configured to move the cooling fluid through the cooling circuit while the cooling fluid is in the supercritical state to cool the machine using the cooling fluid in the supercritical state while the cooling fluid moves in the cooling circuit.
10. The cooling system of clause 9, wherein the one or more pumps are configured to move the cooling fluid through the cooling circuit and cool the machine using the cooling fluid in the supercritical state without evaporating or condensing the cooling fluid.
11. The cooling system of clause 9 or 10, wherein the one or more pumps are configured to move the cooling fluid through the cooling circuit by pumping the cooling fluid through conduits that form the cooling circuit without condensing the cooling fluid.
12. The cooling system of any of clauses 9 to 11, wherein the supercritical pressure of the cooling fluid is a pressure at which the cooling fluid transitions from a liquid state to a supercritical state at the temperature to which the cooling circuit is exposed.
13. The cooling system of any of clauses 9 to 12, further comprising a controller configured to monitor the pressure of the cooling fluid and to control the one or more pumps to maintain the cooling fluid in the supercritical state above the supercritical pressure while cooling the machine.
14. The cooling system of any of clauses 9 to 13, further comprising one or more temperature sensors and a controller configured to monitor a temperature of the cooling fluid using the one or more temperature sensors, wherein the controller is configured to activate the one or more pumps to begin increasing the pressure of the cooling fluid responsive and subsequent to the temperature of the cooling fluid increasing above a supercritical temperature limit associated with the supercritical state of the cooling fluid.
15. The cooling system of any of clauses 9 to 14, wherein the cooling fluid is a refrigerant.
16. The cooling system of any of clauses 9 to 15, wherein the machine includes one or more of an electric motor or a transformer.
17. A supercritical state cooling system, the cooling system comprising:
   a cooling circuit formed from one or more conduits disposed in or alongside a machine;
   one or more temperature sensors configured to measure a temperature of a cooling fluid in the cooling circuit; and
   a controller configured to monitor the temperature of the cooling fluid and a pressure of the cooling fluid in the cooling circuit, the controller configured to activate one or more pumps to increase the pressure of the cooling fluid to above a supercritical pressure limit responsive and subsequent to the temperature of the cooling fluid increasing above a supercritical temperature limit associated with a supercritical state of the cooling fluid,
   wherein the controller is configured to control the one or more pumps to increase the pressure of the cooling fluid to above the supercritical pressure of the cooling fluid to keep the cooling fluid in the supercritical state while the cooling fluid moves in the cooling circuit to cool the machine.
18. The cooling system of clause 17, wherein the one or more pumps are configured to move the cooling fluid through the cooling circuit and cool the machine using the cooling fluid in the supercritical state without evaporating or condensing the cooling fluid.
19. The cooling system of clause 17 or 18, wherein the supercritical pressure of the cooling fluid is the pressure of the cooling fluid at which the cooling fluid transitions from a liquid state to a supercritical state as a function of the temperature of the cooling fluid.
20. The cooling system of any of clauses 17 to 19, wherein the cooling fluid is a refrigerant.

## Claims

1. A method (300) comprising:
increasing a pressure of a cooling fluid in a cooling circuit (206) to above a supercritical pressure of the cooling fluid, wherein the cooling fluid is in a supercritical state at a temperature to which the cooling circuit (206) is exposed;
moving the cooling fluid through the cooling circuit (206) while the cooling fluid is in the supercritical state; and
cooling a machine (202) using the cooling fluid in the supercritical state while the cooling fluid moves in the cooling circuit (206).

2. The method (300) of claim 1, wherein moving the cooling fluid through the cooling circuit (206) and cooling the machine (202) using the cooling fluid in the supercritical state does not include evaporating or condensing the cooling fluid.

3. The method (300) of claim 1 or 2, wherein moving the cooling fluid through the cooling circuit (206) includes pumping the cooling fluid through conduits that form the cooling circuit (206) without condensing the cooling fluid.

4. The method (300) of any of claims 1 to 3, wherein the supercritical pressure of the cooling fluid is a pressure at which the cooling fluid transitions from a liquid state to a supercritical state at the temperature to which the cooling circuit (206) is exposed.

5. The method (300) of any of claims 1 to 4, further comprising maintaining the cooling fluid in the supercritical state above the supercritical pressure while cooling the machine (202).

6. The method (300) of any of claims 1 to 5, wherein moving the cooling fluid through the cooling circuit (206) includes activating one or more pumps (208) that move the cooling fluid through conduits of the cooling circuit (206) responsive and subsequent to the temperature to which the cooling circuit (206) is exposed increasing above a supercritical temperature limit associated with the supercritical state of the cooling fluid.

7. The method (300) of any of claims 1 to 6, wherein the cooling fluid is a refrigerant.

8. The method (300) of any of claims 1 to 7, wherein the machine (202) includes one or more of an electric motor or a transformer.

9. A supercritical state cooling system (200), the cooling system (200) comprising:
a cooling circuit (206) formed from one or more conduits disposed in or alongside a machine (202); and
one or more pumps (208) fluidly coupled with the cooling circuit (206), the one or more pumps (208) configured to increase a pressure of a cooling fluid in the cooling circuit (206) to above a supercritical pressure of the cooling fluid, wherein the cooling fluid is in a supercritical state at a temperature to which the cooling circuit (206) is exposed,
wherein the one or more pumps (208) also are configured to move the cooling fluid through the cooling circuit (206) while the cooling fluid is in the supercritical state to cool the machine (202) using the cooling fluid in the supercritical state while the cooling fluid moves in the cooling circuit (206).

10. The cooling system (200) of claim 9, wherein the one or more pumps (208) are configured to move the cooling fluid through the cooling circuit (206) and cool the machine (202) using the cooling fluid in the supercritical state without evaporating or condensing the cooling fluid.

11. The cooling system (200) of claim 9 or 10, wherein the one or more pumps (208) are configured to move the cooling fluid through the cooling circuit (206) by pumping the cooling fluid through conduits that form the cooling circuit (206) without condensing the cooling fluid.

12. The cooling system (200) of any of claims 9 to 11, wherein the supercritical pressure of the cooling fluid is a pressure at which the cooling fluid transitions from a liquid state to a supercritical state at the temperature to which the cooling circuit (206) is exposed.

13. The cooling system (200) of any of claims 9 to 12, further comprising a controller (210) configured to monitor the pressure of the cooling fluid and to control the one or more pumps (208) to maintain the cooling fluid in the supercritical state above the supercritical pressure while cooling the machine (202).

14. The cooling system (200) of any of claims 9 to 13, further comprising one or more temperature sensors (212) and a controller (210) configured to monitor a temperature of the cooling fluid using the one or more temperature sensors (212), wherein the controller (210) is configured to activate the one or more pumps (208) to begin increasing the pressure of the cooling fluid responsive and subsequent to the temperature of the cooling fluid increasing above a supercritical temperature limit associated with the supercritical state of the cooling fluid.

15. The cooling system (200) of any of claims 9 to 14, wherein the cooling fluid is a refrigerant.
